Europäisches Patentamt

European Patent Office

Office européen des brevets

(19)

(11) Veröffentlichungsnummer : **0 198 159**
**B1**

(12) **EUROPÄISCHE PATENTSCHRIFT**

(45) Veröffentlichungstag der Patentschrift :
05.04.89

(21) Anmeldenummer : 86101021.3

(22) Anmeldetag : 25.01.86

(51) Int. Cl.⁴ : **C 22 C  9/06**, C 22 C  9/00,
H 01 L 23/48

(54) **Verwendung einer Kupfer-Titan-Kobalt-Legierung als Werkstoff für elektronische Bauteile.**

(30) Priorität : 02.04.85 DE 3511999

(43) Veröffentlichungstag der Anmeldung :
22.10.86 Patentblatt 86/43

(45) Bekanntmachung des Hinweises auf die Patenterteilung : 05.04.89 Patentblatt 89/14

(84) Benannte Vertragsstaaten :
BE CH FR GB IT LI LU NL SE

(56) Entgegenhaltungen :
US–A– 3 201 234
CHEMICAL ABSTRACTS, Band 99, Nr. 4, 25. Juli 1983,
Seite 252, Zusammenfassung Nr. 26597u, Columbus,
Ohio, US; & PL - A - 115 185 (INSTYTUT METALI
NIEZELAZNYCH) 30-06-1982
CHEMICAL ABSTRACTS, Band 104, Nr. 22, 2. Juni
1986, Seite 303, Zusammenfassung Nr. 191246h,
Columbus, Ohio, US; & JP - A - 60 218 440 (FURU-
KAWA ELECTRIC CO. LTD.) 01-11-1985
CHEMICAL ABSTRACTS, Band 104, Nr. 16, 21. April
1986, Seite 278, Zusammenfassung Nr. 134413m,
Columbus, Ohio, US; & JP - A - 60 184 655 (HITACHI
METALS LTD.) 20-09-1985

(73) Patentinhaber : Wieland-Werke AG
Postfach 4240 Graf-Arco-Strasse
D-7900 Ulm (Donau) (DE)

(72) Erfinder : Dürrschnabel, Wolfgang, Dr.rer.nat.,Dipl.-
Ing.
Am Schlossberg 4
D-7919 Bellenberg (DE)
Erfinder : Puckert, Franz J., Dr.rer.nat.,Dipl.-Ing.
Giessenweg 11
D-7901 Illerrieden (DE)
Erfinder : Stüer, Heinrich, Dr. Dipl.-Phys.
Bayerstrasse 7
D-7917 Vöhringen (DE)

EP 0 198 159 B1

**Beschreibung**

Die Erfindung bezieht sich auf die Verwendung von Kupferlegierungen als Werkstoff für elektronische Bauteile, insbesondere Halbleiterträger für Transistoren, integrierte Schaltungen, und Teile für die Autoelektrik.

Werkstoffe für elektronische Bauteile, insbesondere Halbleiterträger der genannten Art (sogenannte lead frames), müssen besondere Eigenschaftskombinationen aufweisen :

a) die elektrische und thermische Leitfähigkeit sollte möglichst hoch sein (etwa oberhalb 50 % IACS) ;

b) es wird eine hohe mechanische Festigkeit gefordert ;

c) es wird darüber hinaus eine hohe Erweichungsbeständigkeit gefordert. Ein Maß für die Erweichungsbeständigkeit ist dabei die sogenannte Halbhärtetemperatur $T_H$, die aus der Erweichungskurve (Vickershärte HV als Funktion der Glühtemperatur T) gewonnen wird. Dabei ist die Halbhärtetemperatur $T_H$ dem Wert $HV_{min}$ + ($HV_{max}$ — $HV_{min}$)/2 zugeordnet ;

d) es werden in zunehmendem Maße homogene Werkstoffe gefordert, d. h. Werkstoffe, deren Gefüge keine groben Ausscheidungen oder Einschlüsse enthält, damit eine einwandfreie Verbindung zwischen den sogenannten Bonddrähten und dem Halbleiterträger gewährleistet ist.

Für den genannten Anwendungsfall werden bisher in großem Umfang u. a. Eisen-Nickel-Legierungen oder Kupfer-Eisen-Legierungen, beispielsweise CuFe2 (C 19400) oder CuFeSnP (C 19520) eingesetzt. Dabei lassen insbesondere noch die elektrische Leitfähigkeit und wegen des relativ hohen Legierungsanteils auch die Homogenität der Werkstoffe zu wünschen übrig.

Für Anschlußteile in der Autoelektrik wird wegen der hohen Strombelastung ein Werkstoff mit möglichst hoher elektrischer Leitfähigkeit bei gleichzeitig hoher Festigkeit und damit ausreichender mechanischer Stabilität gefordert.

Der Erfindung liegt daher die Aufgabe zugrunde, die vorgenannten Nachteile zu beseitigen und einen Werkstoff für elektronische Bauteile, insbesondere Halbleiterträger für Transistoren, integrierte Schaltungen, und Teile für die Autoelektrik vorzuschlagen, der besonders günstige Eigenschaften aufweist.

Die Aufgabe wird erfindungsgemäß durch die Verwendung einer Kupfer-Titan-Kobalt-Legierung gelöst, die aus 0,05 bis 0,6 % Titan ; 0,05 bis 0,6 % Kobalt ; Rest Kupfer und übliche Verunreinigungen besteht (die Prozentangaben beziehen sich auf das Gewicht). Vorteile dieser Zusammensetzung werden noch näher anhand des Ausführungsbeispiels erläutert.

Aus der DE-PS 593 783 ist zwar eine ternäre Kupferlegierung bekannt, die maximal 4 % Titan und einen Zusatz eines der Elemente Nickel, Chrom, Mangan, Eisen, Kobalt oder Molybdän in einer Menge bis zu 10 % enthalten kann. Dadurch wird jedoch der erfindungsgemäße Verwendungszweck nicht nahegelegt, zumal diese ternären Legierungen vorzugsweise als Konstruktionsmaterial beispielsweise in Form von Preßstangen, Rohren und dgl. Verwendung finden und dabei zwar die Forderung nach hoher Festigkeit, nicht jedoch die gleichzeitigen Anforderungen an die elektrische Leitfähigkeit erfüllen.

Nach einer besonderen Ausführungsform der vorliegenden Erfindung wird eine Legierung verwendet, die aus 0,2 bis 0,5 % Titan ; 0,2 bis 0,5 % Kobalt ; Rest Kupfer besteht.

Besonders gute Wertekombinationen stellen sich ein, wenn das Verhältnis des Titangehalts zum Kobaltgehalt Ti/Co = 1 ... 1,5, beträgt.

Die Erfindung wird anhand des folgenden Ausführungsbeispiels näher erläutert :

Tabelle 1 zeigt die Zusammensetzung einer erfindungsgemäßen Legierung :

Tabelle 1

Zusammensetzung der Probe (Angaben in Gew.-%)

| Proben-bezeichnung | Ti | Co | Cu |
|---|---|---|---|
| 1 | 0,10 | 0,10 | Rest |

Die Legierung wurde auf folgende Weise hergestellt :

In einem Tammann-Ofen wurde Kathoden-Kupfer bei etwa 1 200 °C unter Holzkohlenabdeckung erschmolzen. Anschließend wurden die Legierungselemente Titan und Kobalt in Form geeigneter Vorlegierungen der Schmelze zugesetzt. Die Vorlegierungen enthielten 28,0 Gew.-% Titan und 14,8 % Gew.-% Kobalt in reiner Form. Nach vollständiger Auflösung der Legierungselemente wurde die Schmelze in eine Eisenkokille der Abmessung 25 × 50 × 100 mm vergossen. Anschließend wurde der Gußblock bei 900 °C/1 h homogenisiert und kontinuierlich an Luft abgekühlt. Dem Kaltwalzen auf eine Zwischendicke von 0,75 mm folgte eine Glühbehandlung bei 500 °C/1 h sowie ein Beizen in verdünnter Schwefelsäure zur Entfernung der Zunderschicht. Nach einer Schlußabwalzung um 60 % wurden die Zugfestigkeit, Halbhärtetemperatur, Vickershärte und die elektrische Leitfähigkeit ermittelt.

Die mechanischen und elektrischen Eigenschaften der Probe sind in Tabelle 2 zusammengestellt, zusammen mit den entsprechenden Werten für Legierungen aus dem Stand der Technik, welche der Literatur entnommen wurden (vgl. beispielsweise die Firmenschrift « Leadframe Materials from Tamagawa » (1983), insbesondere Seite 3, 4, 10 der Firma Tamagawa Metal & Machinery Co., LTD.).

Tabelle 2

Elektrische und mechanische Eigenschaften (Zustand hart, um 60 % kaltverformt, Banddicke 0,3 mm)

| Proben-bezeichng. | Zugfestigkeit (N/mm²) | Halbhärte-temperatur $T_H$ (°C) | Vickershärte HV | elektrische Leit-fähigkeit (% IACS) |
|---|---|---|---|---|
| 1 | 479 | 450 | 140 | 77 |
| CuFe2P (C 19400) | 480 | 400 | 145 | 65 |
| CuFeSnP (C 19520) | 540 | 450 | 165 | 48 |
| CuZn15 (C 23000) | 450 | 380 | 135 | 37 |

Es zeigt sich, daß die erfindungsgemäße Legierunge 1 insbesondere eine wesentlich höhere Leitfähigkeit als die Legierungen nach dem Stand der Technik aufweist.

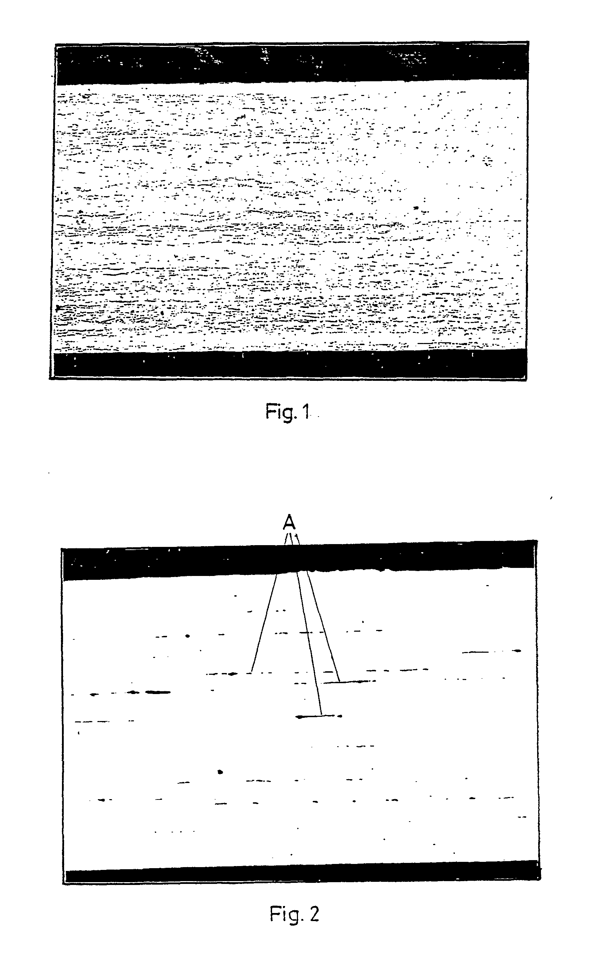

Die ausgezeichneten mechanischen und elektrischen Eigenschaften der erfindungsgemäßen Legierungen ergeben sich durch Ausscheidungen der beteiligten Legierungselemente in bestimmter stöchiometrischer Zusammensetzung. Die Ausscheidungsteilchen sind extrem fein und homogen in der Matrixphase verteilt, so daß eine Identifizierung derselben unter dem Lichtmikroskop auch bei hoher Vergrößerung kaum möglich ist. Die Figur 1 zeigt in einer Vergrößerung von 200 : 1 das geätzte Gefüge einer erfindungsgemäßen Legierung im walzharten Zustand. Im Vergleich dazu zeigt die Figur 2 in einer Vergrößerung von 100 : 1 das ungeätzte Gefüge einer CuFe2P-Probe (C 19400), wobei die in Walzrichtung verstreckten groben Eisenausscheidungen A deutlich zu erkennen sind.

Auf Grund dieser günstigen Ausscheidungscharakteristik weisen die erfindungsgemäßen Legierungen neben den bereits erwähnten guten Leitfähigkeits- und Festigkeitswerten auch eine gute Biegbarkeit auf, die bei Werkstoffen mit gröberen Ausscheidungsteilchen, wie z. B. CuFe2P (C 19400), erst durch eine spezielle Anlaßbehandlung erreicht wird. Darüberhinaus ist eine einwandfreie Verbindung zwischen Bonddrähten und Halbleiterträger möglich.

## Patentansprüche

1. Verwendung einer Kupfer-Titan-Kobalt-Legierung, bestehend aus 0,05 bis 0,6 % Titan, 0,05 bis 0,6 % Kobalt, Rest Kupfer mit üblichen Verunreinigungen, als Werkstoff für elektronische Bauteile und Teile für die Autoelektrik.

2. Verwendung einer Kupferlegierung nach Anspruch 1, die aus 0,2 bis 0,5 % Titan, 0,2 bis 0,5 % Kobalt, Rest Kupfer besteht, für den Zweck nach Anspruch 1.

3. Verwendung einer Kupferlegierung nach den Ansprüchen 1 oder 2, bei der das Verhältnis des Titangehalts zum Kobaltgehalt Ti/Co = 1 ... 1,5 beträgt.

## Claims

1. Use of a copper-titanium-cobalt alloy consisting of 0.05 to 0.6 % titanium, 0.05 to 0.6 % cobalt, the balance being copper, and the usual impurities, for electronic components and parts for automotive electrics.

2. Use of a copper alloy according to Claim 1 consisting of 0.2 to 0.5 % titanium, 0.2 to 0.5 % cobalt, the balance being copper, for the purpose according to Claim 1.

3. Use of a copper alloy according to Claim 1 or 2 wherein the ratio of the titanium content to the cobalt content Ti/Co = 1 ... 1.5.

**Revendications**

1. Utilisage d'un alliage cuivre-titane-cobalt composé de 0,05 à 0,6 % de titane, de 0,05 à 0,6 % de cobalt, le reste étant constitué par le cuivre, avec les impuretés habituelles, pour les composants électroniques et pour l'électricité automobile.

2. Utilisage d'un alliage cuivreux selon la revendication 1 composé de 0,2 à 0,5 % de titane, de 0,2 à 0,5 % de cobalt, le reste étant cuivre, pour l'emploi selon la revendication 1.

3. Utilisage d'un alliage cuivreux selon la revendication 1 ou 2, le rapport entre la teneur en titane et celle en cobalt Ti/Co étant 1 ... 1,5.

Fig. 1

Fig. 2